# EUROPÄISCHE PATENTSCHRIFT

(11) **EP 0 524 219 B1**
(45) Veröffentlichungstag und Bekanntmachung des Hinweises auf die Patenterteilung: **05.10.1994**
(21) Anmeldenummer: 91907234.8
(22) Anmeldetag: 08.04.1991
(51) Int. Cl.: G02F 1/025, G02B 6/12, H01L 31/105

(54) **HALBLEITERELEMENT MIT EINER SILIZIUM-SCHICHT**
SEMICONDUCTOR COMPONENT WITH A SILICON LAYER
ELEMENT SEMICONDUCTEUR AVEC UNE COUCHE EN SILICIUM

(30) Priorität: 09.04.1990 DE 4011860
(43) Veröffentlichungstag der Anmeldung: 27.01.1993
(73) Patentinhaber: SIEMENS AKTIENGESELLSCHAFT, 80333 München (DE)
(72) Erfinder: SCHÜPPERT, Bernd, D-1000 Berlin 31 (DE); SPLETT, Armin, D-1000 Berlin 41 (DE); SCHMIDTCHEN, Joachim, D-1000 Berlin 20 (DE); PETERMANN, Klaus, D-1000 Berlin 27 (DE)
(86) Internationale Anmeldenummer: DE9100303
(87) Internationale Veröffentlichungsnummer: WO9115798

(56) Entgegenhaltungen:
- US-A- 4 787 691
- US-A- 4 857 973
- IEEE Electron Device Letters, Band EDL-7, Nr. 5, Mai 1986, T.P. Pearsall et al: " Avalanche Gain in GexSi1-x/Si Infrared Waveguide Detectors", Seiten 330-332
- Electronics Letters, vol. 25, no. 22, 26 October 1989, (Stevenage, Herts., GB), B. Schüppert et al.: "Optical channel waveguides in silicon diffused from GeSi alloy", pp 1500-1502.
- IEEE Journal of Quantum Electronics, vol. QE-22, no. 6, June 1986, (New York, US), R.A. Soref et al.: "All-solicon active and passive guided-wave components...", pp 873-879.
- Applied Physics Letters, vol 49, no. 13, 29 September 1986, American Institute of Physics, (New York, US), H. Temkin et al.: "GeO.6Sio.4 drib waveguide avalanche photodetectors for ...", pp 809-811.
- Journal of Applied Physics, vol. 63, no. 6, 15 March 1988, (Woodbury, NY, US), L. Friedman et al.: "Silicon doubleinjection electro-optic modulator with junction gate control", pp 1831-1839.

## Beschreibung

Die Erfindung bezieht sich auf ein opto-elektronisches Halbleiterelement mit einer Silizium-Schicht, mit einem Silizium enthaltenden optischen Wellenleiter im Bereich einer Oberfläche der Silizium-Schicht und mit einer mit äußeren leitfähigen Kontakten verbundenen Diodenstruktur im Bereich derselben Oberfläche der Silizium-Schicht in einer derartigen Anordnung zum Wellenleiter, daß die Diodenstruktur von durch Photonen im Wellenleiter erzeugten Elektron-Lochpaaren in ihrer elektrischen Leitfähigkeit beeinflußbar ist.

Bei einem bekannten Halbleiterelement dieser Art ("IEEE Electron Device Letters", Vol. EDL-7, No. 5, Mai 1986, S. 330 - 332) ist eine optische Welle in einem absorbierenden Wellenleiter geführt, der im Bereich einer Oberfläche einer Silizium-Schicht angeordnet ist und abwechselnd aus Silizium- und Germanium-/Silizium-Schichten aufgebaut ist. Zu dem Wellenleiter ist eine mit äußeren Kontakten verbundene Diodenstruktur in einer derartigen Anordnung vorgesehen, daß die Diodenstruktur in ihrer elektrischen Leitfähigkeit mittels durch Photonen im Wellenleiter erzeugter Elektron-Lochpare beeinflußbar ist. Der Wellenleiter ist von hochdotierten Schichten umgeben. Die hohe Dotierung führt zu hohen Verlusten aufgrund der Absorption freier Ladungsträger. Das bekannte Halbleiterelement ist daher als zum Einsatz als ein eine Kombination von einem integrierten Wellenleiter mit einem Photodetektor darstellendes Bauelement ungeeignet.

Der Erfindung liegt daher die Aufgabe zugrunde, ein opto-elektronisches Halbleiterbauelement auf der Basis von Silizium anzugeben, das einen verlustarmen optischen Wellenleiter enthält und daher zur optisch-elektrischen Wandlung gut geeignet ist.

Zur Lösung dieser Aufgabe ist bei einem Halbleiterelement der eingangs angegebenen Art erfindungsgemäß der Wellenleiter hohe Verluste durch freie Ladungsträger vermeidend schwach dotiert, und Bestandteil der Diodenstruktur ist eine die Elektron-Lochpaare abgebende germaniumreiche Schicht, die benachbart zum Wellenleiter angeordnet ist.

Es ist zwar aus der Veröffentlichung "Monolithic Integration of Photodiodes and Buried Stripe Waveguides on InP" von R. Kaiser u.A., in Proceedings 15th., European Conference on Optical Communication, Vol. 1, Sept. 1989, S. 360 - 363, bekannt, ein Halbleiterbauelement vorzusehen, daß einen verlustarmen Wellenleiter und einen Photodetektor enthält, jedoch ist dieses Halbleiterelement im wesentlichen aus III/V-Halbleitern aufgebaut; bei diesen Halbleitern handelt es sich um sehr aufwendig zu realisierende Halbleitermaterialien, so daß dieses bekannte Halbleiterelement verhältnismäßig aufwendig in der Herstellung ist.

Ein wesentlicher Vorteil des erfindungsgemäßen Halbleiterelementes besteht darin, daß es auf der Basis des weit verbreiteten Siliziums herstellbar ist und somit relativ kostengünstig realisiert werden kann, wobei aufgrund der schwachen Dotierung des optischen Wellenleiters hohe Verluste durch freie Ladungsträger vermieden sind. Dabei ist der Germaniumgehalt in der germaniumreichen Schicht so gewählt, daß der Bandabstand genügend klein wird, so daß Photonen im optischen Wellenleiter zu Elektron-Lochpaaren in der germaniumreichen Schicht führen, wobei durch die Kombination der germaniumreichen Schicht mit der Diodenstruktur eine Trennung der Elektronen und der Löcher erfolgt.

Bei dem erfindungsgemäßen Halbleiterelement erstreckt sich bei einem an einer Oberfläche des Halbleiterelementes befindlichen optischen Wellenleiter die Diodenstruktur vorteilhafterweise quer zum Wellenleiter im Bereich dieser Oberfläche der Silizium-Schicht. Eine solche Ausgestaltung hat den Vorteil, daß eine Dämpfung der optischen Welle am Metall der äußeren leitfähigen Kontakte vermieden wird, weil diese Kontakte bei dieser Ausführungsform des erfindungsgemäßen Halbleiterelementes relativ weit vom optischen Wellenleiter entfernt anbringbar sind.

Ferner hat es sich als vorteilhaft erwiesen, wenn bei dem erfindungsgemäßen Halbleiterelement der optische Wellenleiter ein durch Diffusion aus einem germaniumhaltigen Streifen in die Silizium-Schicht gebildeter Wellenleiter ist. Ein entsprechendes Verfahren zur Herstellung eines derartigen optischen Wellenleiters ist in der älteren deutschen Patentanmeldung P 39 22 009.5 (GR 89 P 8552 DE) beschrieben.

Bei einer anderen Ausführungsform des erfindungsgemäßen Halbleiterelementes ist der optische Wellenleiter vorteilhafterweise eine Rippe einer Germanium-Silizium-Schicht auf der Silizium-Schicht.

Bei einer weiteren Ausführungsform des erfindungsgemäßen Halbleiterelementes ist der optische Wellenleiter vorteilhafterweise eine Rippe in einer schwach dotierten epitaktischen Silizium-Schicht mit isolierender Siliziumdioxid-Zwischenschicht auf einem Silizium-Substrat.

Bei dem erfindungsgemäßen Halbleiterelement befindet sich die germaniumreiche Schicht vorteilhafterweise an der den Wellenleiter aufweisenden Außenfläche des Halbleiterelementes. Dadurch läßt sich nämlich gut erreichen, das Photonen im optischen Wellenleiter zu Elektron-Lochpaaren in dieser Schicht führen, weil sich die germaniumreiche Schicht in unmittelbarer Nähe des optischen Wellenleiters befindet.

Die germaniumreiche Schicht kann im wesentlichen einkristallin sein. Gegebenenfalls kann es auch vorteilhaft sein, wenn die germaniumreiche Schicht eine in einem Hochvakuum auf die beheizte Silizium-Schicht aufgedampfte Schicht ist.

Als vorteilhaft wird es auch angesehen, wenn die germaniumreiche Schicht eine im Hochvakuum auf die Silizium-Schicht aufgedampfte und einem anschließenden Temperprozeß ausgesetzte Schicht ist.

Es hat sich auch als vorteilhaft erwiesen, wenn der Germaniumgehalt der germaniumreichen Schicht größer als 85 % ist. Dies ist insofern vorteilhaft, als für die optische Nachrichtentechnik insbesondere der Wellenlängenbereich
λ= 1,3 bis 1,55 µm von Interesse ist und für diesen Wellenlängenbereich eine Absorption in der germaniumreichen Schicht zu erreichen ist.

Die germaniumreichen Schicht kann sehr dünn ausgeführt sein. Um Grenzflächeneffekte zu reduzieren, sollte die Dicke der germaniumreichen Schicht zwischen 10 nm und 1000 nm liegen.

Die Diodenstruktur kann bei dem erfindungsgemäßen Halbleiterelement in unterschiedlicher Weise ausgebildet sein; als vorteilhaft wird es angesehen, wenn die Diodenstruktur als Pin-Diode ausgebildet ist.

Es kommt aber auch eine Diodenstruktur bei dem erfindungsgemäßen Halbleiterelement in Frage, die durch mindestens eine Schottky-Diode realisiert ist.

Bei dem erfindungsgemäßen Halbleiterelement sind die äußeren leitfähigen Kontakte vorteilhafterweise als parallel zum optischen Wellenleiter verlaufende Kontaktstreifen ausgebildet.

Als Abstand zwischen den Kontaktstreifen hat sich als vorteilhaft ein Abstand von 5 bis 10 µm ergeben; die Länge der Kontaktstreifen beträgt vorteilhafterweise zwischen 100 und 500 µm.

Bei der eben angegebenen Ausgestaltung der äußeren leitfähigen Kontakte erstreckt sich die qermaniumreiche Schicht bei einer Anordnung auf der den Wellenleiter tragenden Außenfläche der Silizium-Schicht vorteilhafterweise vom Wellenleiter bis unter die Kontaktstreifen.

Zur Erläuterung der Erfindung ist in
Figur 1 ein Ausführungsbeispiel des erfindungsgemäßen Halbleiterelementes mit in eine Silizium-Schicht eindiffundiertem Wellenleiter, in
Figur 2 ein weiteres Ausführungsbeispiel mit einem von einer Rippe einer germaniumhaltigen Schicht gebildeten Wellenleiter, in
Figur 3 ein zusätzliches Ausführungsbeispiel mit einem von einer Rippe einer germaniumhaltigen Schicht auf einer Siliziumdioxid-Zwischenschicht eines Silizium-Substrats gebildeten Wellenleiter und in
Figur 4 ein anderes Ausführungsbeispiel mit zwei gegensinnig geschalteten Schottky-Dioden wiedergegeben; von sämtlichen Ausführungsbeispielen ist in den Figuren ein Querschnitt wiedergegeben.

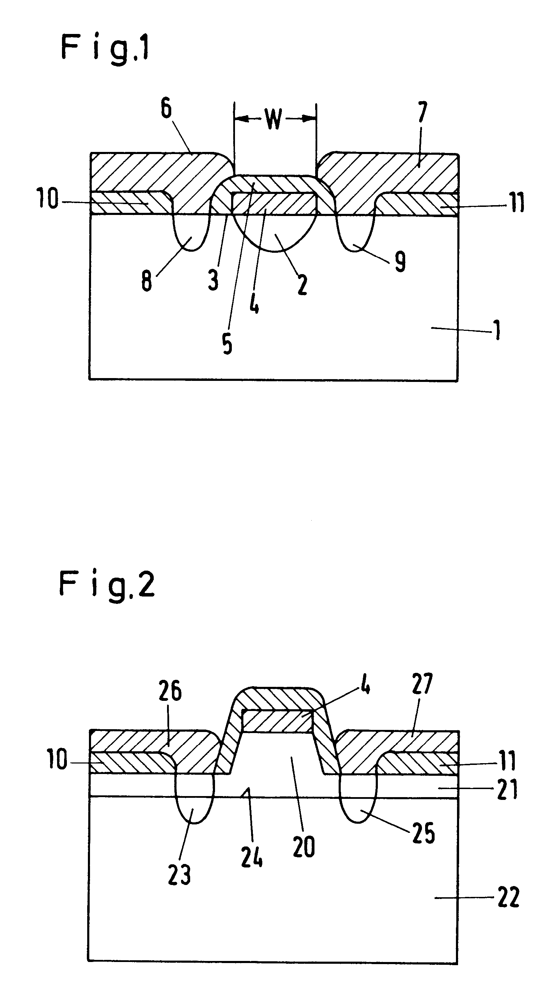

Bei dem Ausführungsbeispiel nach Figur 1 ist auf einer schwach dotierten Silizium-Schicht 1 durch Eindiffundieren aus einem germaniumhaltigen Streifen entsprechend der älteren deutschen Anmeldung P 39 22 009.5 ein Wellenleiter 2 an der Oberfläche 3 der Silizium-Schicht 1 gebildet. Im Bereich des Wellenleiters 2 ist auf der Oberfläche 3 der Silizium-Schicht 1 eine germaniumreiche Schicht 4 aufgebracht. Diese Schicht 4 ist mit einer Siliziumdioxid-Schicht 5 überzogen, so daß die germaniumreiche Schicht 4 gegenüber äußeren leitfähigen Kontakten 6 und 7 auf der Oberfläche 3 der Silizium-Schicht 1 isoliert ist.

Wie Figur 1 ferner erkennen läßt, ist in der Silizium-Schicht 1, die auf einem - nicht dargestellten - hochdotierten Substrat aufgebracht sein kann, ein p⁺-Bereich 8 auf der einen Seite des Wellenleiters 2 und ein n⁺-Bereich 9 auf der anderen Seite des optischen Wellenleiters 2 vorhanden. Diese Bereiche 8 und 9 bilden mit der germaniumreichen Schicht 4 und dem Bereich des Wellenleiters 2 eine Pin-Diode. Weitere Siliziumdioxid-Schichten 10 und 11 dienen zur Isolation zwischen den äußeren leitfähigen Kontakten 6 und 7 und der Silizium-Schicht 1.

Bei dem in Figur 1 dargestellten Ausführungsbeispiel des erfindungsgemäßen Halbleiterelementes entstehen aufgrund eines optischen Feldes im optischen Wellenleiter 2 in der germaniumreichen Schicht 4 Elektron-Lochpaare, die infolge des Pin-Dioden-Aufbaus zu einem Strom durch die leitfähigen Kontakte 6 und 7 führen. Die Breite des optischen Wellenleiters 2 liegt im Bereich weniger µm, so daß der Abstand zwischen den sich quer zur Zeichenbene als Kontaktstreifen erstreckenden leitfähigen Kontakten 6 und 7 etwa zwischen 5 und 10 µm liegt.

Das Ausführungsbeispiel nach Figur 2 unterscheidet sich von dem nach Figur 1 im wesentlichen dadurch, daß der optische Wellenleiter von einer Rippe 20 einer germaniumhaltigen Schicht 21 gebildet ist, die auf einer schwach dotierten Silizium-Schicht 22 entsprechend der Silizium-Schicht 1 gemäß dem Ausbeispiel nach Figur 1 aufgebracht ist. Ein p⁺-Bereich 23 erstreckt sich bei diesem Ausführungsbeispiel von der Oberfläche 24 der Silizium-Schicht 22 durch die germaniumhaltige Schicht 21 bis in die Silizium-Schicht 22 hinein. Entsprechend ist ein n⁺-Bereich 25 ausgestaltet. Auch bei diesem Ausführungsbeispiel bilden die Bereiche 23 und 25 mit der germaniumreichen Schicht 14 und der Rippe 20 eine Pin-Diode, über die aufgrund von in der germaniumreichen Schicht 4 durch das optische Feld gebildeten Elektron-Lochpaaren ein Strom durch äußere leitfähige Kontakte 26 und 27 fließt, der ein Maß für das optische Feld darstellt.

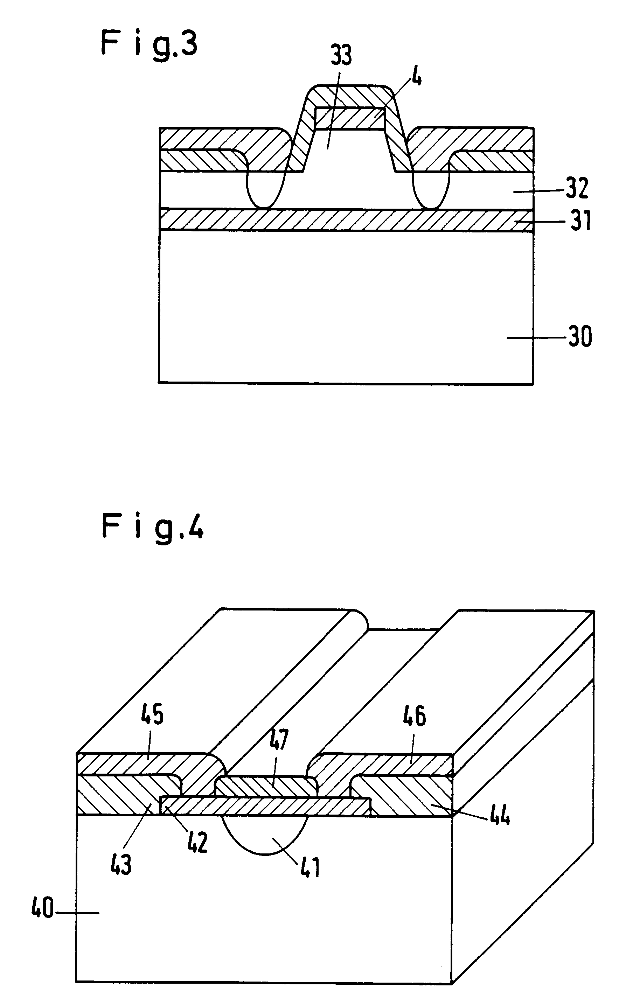

Das Ausführungsbeispiel nach Figur 3 unterscheidet sich von dem nach Figur 2 dadurch, daß auf einem beliebig dotierten Silizium-Substrat 30 zur Isolation eine Siliziumdioxid-Schicht 31 aufgebracht ist, auf der eine schwach dotierte einkristalline Silizium-Schicht 32 liegt. Eine Rippe 33 dieser Silizium-Schicht 32 bildet den optischen Wellenleiter. Im übrigen ist der Aufbau mit dem nach Figur 2 vergleichbar.

Bei dem Ausführungsbeispiel nach Figur 4 ist auf eine schwach dotierte Silizium-Schicht 40 zunächst durch Diffusion in oben beschriebener Weise (vgl. Fig. 1) ein Wellenleiter 41 gebildet. Über den Bereich des Wellenleiters 41 hinweg ist eine germaniumreiche Schicht 42 gezogen, die sich bis in den Bereich von isolierenden Siliziumdioxid-Schichten 43 und 44 erstreckt. Die se Schichten 43 und 44 isolieren leitfähige Kontakte 45 und 46 gegenüber der Silizium-Schicht 40. Im Bereich oberhalb des Wellenleiters 41 ist eine weitere Siliziumdioxid-Schicht 47 zur Isolierung aufgebracht. Bei diesem Ausführungsbeispiel stellt der Übergang zwischen dem leitfähigen Kontakt 45 und der germaniumreichen Schicht 42 bzw. der Silizium-Schicht 40 und der Übergang zwischen der Silizium-Schicht 40 bzw. der germaniumreichen Schicht 42 und dem leitfähigen Kontakt 46 jeweils einen Schottky-Kontakt dar, so daß zwischen den leitfähigen Kontakten 45 und 46 zwei gegensinnig geschaltete Schottky-Dioden aufgebaut sind, von denen jeweils eine in Sperrichtung und die andere in Flußrichtunq betrieben wird.

Wie Figur 4 deutlich zeigt, sind der optische Wellenleiter 41 sowie die äußeren leitfähigen Kontakte 45 und 46 streifenförmig ausgebildet. Die leitfähigen Kontakte 45 und 46 haben je nach der Absorption typischerweise eine Länge zwischen 100 µm und 500 µm.

Bei der dargestellten Ausführung mit der bis zu den leitfähigen Kontakten 45 und 46 reichenden germaniumreichen Schicht 42 läßt sich der Stromfluß zwischen den Kontakten 45 und 46 im wesentlichen auf die germaniumreiche Schicht 42 begrenzen. Prinzipiell ist es aber auch möglich, die germaniumreiche Schicht 42 nur im Bereich des Wellenleiters 41 vorzusehen.

## Patentansprüche

1. Opto-elektronisches Halbleiterelement mit einer Silizium- Schicht (1), mit einem Silizium enthaltenden optischen Wellenleiter (2) im Bereich einer Oberfläche (3) der Silizium Schicht (1) und mit einer mit äußeren leitfähigen Kontakten (6, 7) verbundenen Diodenstruktur im Bereich derselben Oberfläche (3) der Silizium-Schicht (1) in einer derartigen Anordnung zum Wellenleiter (2), daß die Diodenstruktur von durch Photonen im Wellenleiter (2) erzeugten Elektron-Lochpaaren in ihrer elektrischen Leitfähigkeit beeinflußbar ist,
**dadurch gekennzeichnet,** daß
der Wellenleiter (2) hohe Verluste durch freie Ladungsträger vermeidend schwach dotiert ist und daß Bestandteil der Diodenstruktur eine die Elektron-Lochpaare abgebende germaniumreiche Schicht (4) ist, die benachbart zum Wellenleiter (2) angeordnet ist.

2. Halbleiterelement nach Anspruch 1,
**dadurch gekennzeichnet,** daß
sich bei einem an einer Oberfläche der Silizium-Schicht (1) befindlichen optischen Wellenleiter (2) die Diodenstruktur quer zum Wellenleiter (2) im Bereich dieser Oberfläche der Silizium-Schicht (1) erstreckt.

3. Halbleiterelement nach Anspruch 1 oder 2,
**dadurch gekennzeichnet,** daß
der optische Wellenleiter ein durch Diffusion aus einem germaniumhaltigen Streifen in der Silizium-Schicht (1) gebildeter Wellenleiter (2) ist.

4. Halbleiterelement nach Anspruch 1 oder 2,
**dadurch gekennzeichnet,** daß
der optische Wellenleiter eine Rippe (20) einer Germanium-Silizium-Schicht (21) auf der Silizium-Schicht (22) ist.

5. Halbleiterelement nach Anspruch 1 oder 2,
**dadurch gekennzeichnet,** daß
der optische Wellenleiter eine Rippe (33) in einer schwach dotierten epitaktischen Siliziumschicht (32) mit isolierender Siliziumdioxid-Zwischenschicht (31) auf einem Silizium-Substrat (30) ist.

6. Halbleiterelement nach einem der vorangehenden Ansprüche,
**dadurch gekennzeichnet,** daß
sich die germaniumreiche Schicht (4) an der den Wellenleiter (2) aufweisenden Oberfläche der Silizium-Schicht (1) befindet.

7. Halbleiterelement nach Anspruch 6,
**dadurch gekennzeichnet,** daß
die germaniumreiche Schicht (4) im wesentlichen einkristallin ist.

8. Halbleiterelement nach Anspruch 6 oder 7,
**dadurch gekennzeichnet,** daß
die germaniumreiche Schicht eine im Hochvakuum auf die beheizte Silizium-Schicht (1) aufgedampfte Schicht (4) ist.

9. Halbleiterelement nach Anspruch 6 oder 7,
**dadurch gekennzeichnet,** daß
die germaniumreiche Schicht eine im Hochvakuum auf die Silizium-Schicht (1) aufgedampfte und einem anschließenden Temperprozeß ausgesetzte Schicht (4) ist.

10. Halbleiterelement nach einem der vorangehenden Ansprüche,
**dadurch gekennzeichnet**, daß
der Germaniumgehalt der germaniumreichen Schicht (4) größer ist als 85 %.

11. Halbleiterelement nach einem der voranqehenden Ansprüche,
**dadurch gekennzeichnet,** daß
die Dicke der germaniumreichen Schicht (4) zwischen 10 nm und 1000 nm liegt.

12. Halbleiterelement nach einem der vorangehenden Ansprüche,
**dadurch gekennzeichnet,** daß
die Diodenstruktur als pin-Diode ausgebildet ist.

13. Halbleiterelement nach einem der Ansprüche 1 bis 11,
**dadurch gekennzeichnet,** daß
die Diodenstruktur durch mindestens eine Schottky-Diode realisiert ist.

14. Halbleiterelement nach einem der vorangehenden Ansprüche,
**dadurch gekennzeichnet,** daß
die leitfähigen Kontakte als parallel zum optischen Wellenleiter (41) verlaufende Kontaktstreifen (45, 46) ausgebildet sind.

15. Halbleiterelement nach Anspruch 14,
**dadurch gekennzeichnet,** daß
der Abstand der Kontaktstreifen (45, 46) zwischen 5 und 10 µm und die Länge der Kontaktstreifen (45, 46) zwischen 100 und 500 µm beträgt.

16. Halbleiterelement nach Anspruch 14 oder 15,
**dadurch gekennzeichnet,** daß
sich die germaniumreiche Schicht (4) bei einer Anordnung auf der den Wellenleiter (41) tragenden Oberfläche der Silizium-Schicht (40) vom Wellenleiter (41) bis unter die Kontaktstreifen (45, 46) erstreckt.

## Claims

1. Opto-electronic semiconductor element with a silicon layer (1), having an optical waveguide (2) containing silicon in the region of one surface (3) of the silicon layer (1) and having a diode structure connected to external conducting contacts (6, 7) in the region of the same surface (3) of the silicon layer (1) in such an arrangement to the waveguide (2) that the diode structure can be influenced in its electrical conductivity by electron-hole pairs generated by photons in the waveguide (2), characterized in that the waveguide (2) is weakly doped to prevent high losses through free charge carriers and in that a germanium-rich layer (4) emitting electron-hole pairs and located adjacent to the waveguide (2) is a component of the diode structure.

2. Semiconductor element in accordance with claim 1, characterized in that, in the case of an optical waveguide (2) located on one surface of the silicon layer (1), the diode structure extends transversely to the waveguide (2) in the region of this surface of the silicon layer (1).

3. Semiconductor element in accordance with claim 1 or 2, characterized in that the optical waveguide is a waveguide (2) formed in the silicon layer (1) by diffusion from a strip containing germanium.

4. Semiconductor element in accordance with claim 1 or 2, characterized in that the optical waveguide is a rib (20) of a germanium-silicon layer (21) on the silicon layer (22).

5. Semiconductor element in accordance with claim 1 or 2, characterized in that the optical waveguide is a rib (33) in a weakly doped epitaxial silicon layer (32) with insulating silicon dioxide interlayer (31) on a silicon substrate (30).

6. Semiconductor element in accordance with one of the preceding claims, characterized in that the germanium-rich layer (4) is located on the surface of the silicon layer (1) on which the waveguide (2) is found.

7. Semiconductor element in accordance with claim 6, characterized in that the germanium-rich layer (4) is substantially a single crystal.

8. Semiconductor element in accordance with claim 6 or 7, characterized in that the germanium-rich layer is a layer (4) applied onto the heated silicon layer (1) by vapour deposition in a high vacuum.

9. Semiconductor element in accordance with claim 6 or 7, characterized in that the germanium-rich layer is a layer (4) applied onto the silicon layer (1) by vapour deposition in a high vacuum and exposed to a subsequent tempering process.

10. Semiconductor element in accordance with one of the preceding claims, characterized in that the germanium content of the germanium-rich layer (4) is greater than 85%.

11. Semiconductor element in accordance with one of the preceding claims, characterized in that the thickness of the germanium-rich layer (4) is between 10 nm and 1000 nm.

12. Semiconductor element in accordance with one of the preceding claims, characterized in that the diode structure takes the form of a p-i-n diode.

13. Semiconductor element in accordance with one of the claims 1 to 11, characterized in that the diode structure is implemented through at least one Schottky diode.

14. Semiconductor element in accordance with one of the preceding claims, characterized in that the conducting contacts take the form of contact strips (45, 46) running parallel to the optical waveguide (41).

15. Semiconductor element in accordance with claim 14, characterized in that the spacing between the contact strips (45, 46) lies between 5 and 10 µm and the length of the contact strips (45, 46) lies between 100 and 500 µm.

16. Semiconductor element in accordance with claim 14 or 15, characterized in that the germanium-rich layer (4), being applied on the surface of the silicon layer (40) bearing the waveguide (41), extends from the waveguide (41) to beneath the contact strips (45, 46).

## Revendications

1. Élément semiconducteur optoélectronique comportant une couche de silicium (1), un guide d'ondes optiques (2) contenant du silicium et situé dans une partie d'une surface (3) de la couche de silicium (1), et une structure de diode reliée à des contacts conducteurs extérieurs (6, 7), dans la partie de la même surface (3) de la couche de silicium (1), selon une disposition telle par rapport au guide d'ondes (2) que la conductivité électrique de la structure de diode peut être influencée par des paires électron - trou produites par des photons dans le guide d'ondes (2), caractérisé par le fait que le guide d'ondes (2) est faiblement dopé de manière à empêcher de grandes pertes dues à des porteurs de charges libres, et qu'un composant de la structure de diode est une couche (4) riche en germanium, qui délivre des paires électron - trou et qui est disposée au voisinage du guide d'ondes (2).

2. Élément semiconducteur suivant la revendication 1, caractérisé par le fait que, pour un guide d'ondes optiques (2) se trouvant sur une surface de la couche de silicium (1), la structure de diode s'étend transversalement au guide d'ondes (2), dans la partie de cette surface de la couche de silicium (1).

3. Élément semiconducteur suivant la revendication 1 ou 2, caractérisé par le fait que le guide d'ondes optiques est un guide d'ondes (2) qui est formé par diffusion, à partir d'une bande contenant du germanium, dans la couche de silicium (1).

4. Élément semiconducteur suivant la revendication 1 ou 2, caractérisé par le fait que le guide d'ondes optiques est une nervure (20) formée d'une couche de germanium - silicium (21), sur la couche en silicium (22).

5. Élément semiconducteur suivant la revendication 1 ou 2, caractérisé par le fait que le guide d'ondes optiques est une nervure (33) située dans une couche (32) épitaxiale de silicum faiblement dopée et comportant une couche intermédiaire isolante en dioxyde de silicium (31) disposée sur un substrat en silicium (30).

6. Élément semiconducteur suivant l'une des revendications précédentes, caractérisé par le fait que la couche (4) riche en germanium se trouve sur la surface, qui est tournée vers le guide d'ondes (2), de la couche de silicium (1).

7. Élément semiconducteur suivant la revendication 6, caractérisé par le fait que la couche (4) riche en germanium est essentiellement monocristalline.

8. Élément semiconducteur suivant la revendication 6 ou 7, caractérisé par le fait que la couche riche en germanium est une couche déposée par dépôt en phase vapeur sous vide poussé sur la couche de silicium (1) chauffée.

9. Élément semiconducteur suivant la revendication 6 ou 7, caractérisé par le fait que la couche riche en germanium est une couche (4) déposée par dépôt en phase vapeur sous vide poussé sur la couche de silicium (1) et est soumise à un traitement ultérieur de recuit.

10. Élément semiconducteur suivant l'une des revendications précédentes, caractérisé par le fait que la teneur en germanium de la couche riche (4) en germanium est supérieure à 85 %.

11. Élément semiconducteur suivant l'une des revendications précédentes, caractérisé par le fait que l'épaisseur de la couche (4) riche en germanium est comprise entre 10 nm et 1000 nm.

12. Élément semiconducteur suivant l'une des revendications précédentes, caractérisé par le fait que la structure de diode est une diode pin.

13. Élément semiconducteur suivant l'une des revendications 1 à 11, caractérisé par le fait que la structure de diode est constituée d'au moins une diode Schottky.

14. Élément semiconducteur suivant l'une des revendications précédentes, caractérisé par le fait que les contacts conducteurs sont sous la forme de bandes de contact (45, 46), qui sont parallèles au guide d'ondes optiques (41).

15. Élément semiconducteur suivant la revendication 14, caractérisé par le fait que la distance entre les bandes de contact (45, 46) est comprise entre 5 et 10 mm et que la longueur des bandes de contact (45, 46) est comprise entre 100 et 500 mm.

16. Élément semiconducteur suivant la revendication 14 ou 15, caractérisé par le fait que, dans le cas où elle est disposée sur la surface, qui porte le guide d'ondes optiques (41), de la couche de silicium (40), la couche (4) riche en germanium s'étend du guide d'ondes (41) jusqu'au-dessous des bandes de contact (45, 46).
